# EUROPEAN PATENT SPECIFICATION

(11) **EP 4 571 458 B1**
(45) Date of publication and mention of the grant of the patent: **10.09.2025**
(21) Application number: 23307234.7
(22) Date of filing: 15.12.2023
(51) Int. Cl.: G06F 1/20, H05K 7/20

(54) **A MAINTENANCE CLEANSING SYSTEM FOR LIQUID-COOLED RACK-MOUNTED PROCESSING ASSEMBLIES**
WARTUNGSREINIGUNGSSYSTEM FÜR FLÜSSIGKEITSGEKÜHLTE GESTELLMONTIERTE VERARBEITUNGSANORDNUNGEN
SYSTÈME DE NETTOYAGE DE MAINTENANCE POUR ENSEMBLES DE TRAITEMENT MONTÉS SUR BÂTI ET REFROIDIS PAR LIQUIDE

(43) Date of publication of application: 18.06.2025
(73) Proprietor: OVH, 59100 Roubaix (FR)
(72) Inventor: CHEHADE, Ali, 59283 Moncheaux (FR); BAUCHART, Grégory Francis Louis, 59150 Wattrelos (FR); HNAYNO, Mohamad, 59100 Roubaix (FR)
(74) Representative: BCF Global

(56) References cited:
- CN-U- 219 210 946

## Description

### FIELD

The present technology generally relates to the field of datacenter liquid cooling arrangements and, in particular, to the cleansing of existing liquids servicing the liquid cooling needs of rack-mounted processing assemblies.

### BACKGROUND

Datacenters as well as many computer processing facilities house multitudes rack-mounted electronic processing components. In operation, such electronic processing components generate a substantial amount of heat that must be dissipated in order avoid electronic component failures and ensure continued efficient processing operations.

To this end, various liquid cooling measures have been implemented to facilitate the dissipation of heat generated by the electronic processing components. One such measure, is the use of an immersion liquid cooling technique, in which electronic components are fully submerged in a rack casing containing a non-conductive cooling liquid, such as, for example, a dielectric cooling liquid. The immersion of the electronic components within the dielectric cooling liquid achieves adequate thermal contact between the electronic components to dissipate a fair amount of generated heat.

However, there are certain electronic components, such as, for example, high-performance processing units that tend to generate more heat than other electronic components (*e*.*g*., memory boards) and dielectric liquid immersion measures may not serve to sufficiently cool such high heat-generating components. To address the cooling of these high heat-generating components, direct liquid cooling block measures have been implemented, in which liquid cooling blocks having internal channels to circulate cool water therethrough are disposed in direct thermal contact with the high heat-generating components.

The Inventors of the instant application have identified evidence of undesirable contaminants that develop, over time, due to the circulation of channelized water throughout the liquid cooling blocks and corresponding distribution channels and coupling elements. Such evidence of undesirable contaminants includes the buildup of mineral deposits, corrosion, algae, bacteria, *etc.* that affect the quality of the water as well as the efficient flow of the channelized water.

Along these lines, there have been some efforts for cleaning processing cabinets. For example, the CN 219210946 utility model is directed to a small batch cleaning device for a cabinet liquid cooling runner, which comprises a cleaning liquid tank, wherein a liquid feeding end of the cleaning liquid tank is connected with a liquid feeding tank, and a liquid discharging end of the cleaning liquid tank is sequentially connected with a unidirectional booster pump, a main way on-off electromagnetic control valve, a main way monitoring flowmeter, a main way monitoring manometer and a diverter valve. This configuration improves the cleaning efficiency, as it can clean in a single way or multiple ways as well as unify the cleaning standard and improve the utilization rate of the cleaning liquid.

However, there remains an interest in the improvement of eliminating the buildup of such undesirable contaminants as well as reducing reoccurrences of the same in direct liquid cooling block implementations.

The subject matter discussed in the background section should not be assumed to be prior art merely as a result of its mention in the background section. Similarly, a problem mentioned in the background section or associated with the subject matter of the background section should not be assumed to have been previously recognized in the prior art. The subject matter in the background section merely represents different approaches.

### SUMMARY

Embodiments of the present technology have been developed based on certain drawbacks associated with the buildup of various contaminants within mineral deposits, corrosion, algae, bacteria, *etc.* techniques and implementations.

In one aspect of the inventive concepts, the present technology provides a maintenance cleansing system for a liquid-cooled rack-mounted data processing assembly comprising a cleansing unit that incorporates a first tank containing a volume of a first liquid comprising a detergent having an acidic ph level and fluidly-coupled a first fluid control structure, a second tank containing a volume of a second liquid comprising softened or pure water and fluidly-coupled a second fluid control structure, and a third tank containing a volume of a third liquid comprising treated osmosed water with corrosion inhibitors having a basic ph level and fluidly-coupled a third fluid control structure. The system further comprises a control module operably-coupled to the first, second, and third fluid control structures and configured to select one of the first, second, or third liquids and define a corresponding first, second, and third operational cleansing cycle and cycle duration time, a forward fluid coupling section configured to supply the selected liquid to the rack-mounted processing assemblies, and a return fluid coupling section configured to receive the selected liquid from the rack-mounted processing assemblies, a rack unit fluid inlet configured to receive the selected fluid from the forward fluid coupling section and distribute the selected liquid throughout each of the rack-mounted processing assemblies for a corresponding cleansing cycle, and a rack unit fluid outlet configured to receive the distributed selected liquid from each of the rack-mounted processing assemblies, during the corresponding cleansing cycle, and return the distributed selected liquid back to the respective tank.

A feature of the maintenance cleansing system includes a fourth tank containing a volume of a fourth liquid comprising a volume of treated osmosed water with corrosion inhibitors having a basic ph level and fluidly-coupled to a fourth fluid control structure for selection by the control module to establish a corresponding fourth cleansing cycle and cycle duration time.

Another feature of the maintenance cleansing system provides that each of the first, second, third, and fourth fluid control structures comprises a respective supply liquid channel incorporating at least one pump and at least one solenoid valve for providing proper pressure and flow of the selected liquid into the datacenter rack unit.

An additional feature of the maintenance cleansing system provides that each of the first, second, third, and fourth fluid control structures comprises a respective return liquid channel incorporating at least one filter and at least one heat exchanger for recleaning and recooling the returned selected liquid.

Another feature of the maintenance cleansing system is that the cleansing unit performs the first, second, third, and fourth cleansing cycles while the data processing assemblies remain in operation.

Also, a feature of the maintenance cleansing system is that the cleansing unit further comprises a wheel assembly for transportability throughout a datacenter.

In another aspect of the inventive concepts, the present technology provides a maintenance cleansing process for a liquid-cooled rack-mounted data processing assembly comprising defining an operational cleansing cycle and duration time for a first liquid comprising a detergent having an acidic ph level, a second liquid comprising water softening agents, and a third cleansing liquid comprising treated osmosed water having a basic ph level; selecting the first liquid and executing the first operational cleansing cycle for the first duration time to inject and circulate the flow of the first liquid throughout the processing assemblies; upon termination of the first operational cleansing cycle, selecting the second liquid and executing the second operational cleansing cycle for the second duration time to inject and circulate the flow of the second liquid throughout the processing assemblies; and upon termination of the second operational cleansing cycle, selecting the third liquid and executing the third operational cleansing cycle for the third duration time to inject and circulate the flow of the third liquid throughout the processing assemblies.

An additional feature of the maintenance cleansing process comprises defining an operational cleansing cycle and duration time for a fourth liquid comprising treated osmosed water having a basic ph level in which, upon detecting remaining contaminants and/or significant drop in ph levels, selecting the fourth liquid and executing the fourth operational cleansing cycle for the fourth duration time to inject and circulate the flow of the fourth liquid throughout the processing assemblies.

In the context of the present specification, unless expressly provided otherwise, a computer system may refer, but is not limited to, an "electronic device", an "operation system", a "system", a "computer-based system", a "controller unit", a "monitoring device", a "control device" and/or any combination thereof appropriate to the relevant task described.

In the context of the present specification, unless expressly provided otherwise, the expression "computer-readable medium" and "memory" are intended to include media of any nature and kind whatsoever, non-limiting examples of which include RAM, ROM, disks (CD-ROMs, DVDs, floppy disks, hard disk drives, etc.), USB keys, flash memory cards, solid state-drives, and tape drives. Still in the context of the present specification, "a" computer-readable medium and "the" computer-readable medium should not be construed as being the same computer-readable medium. To the contrary, and whenever appropriate, "a" computer-readable medium and "the" computer-readable medium may also be construed as a first computer-readable medium and a second computer-readable medium.

In the context of the present specification, unless expressly provided otherwise, the words "first", "second", "third", etc. have been used as adjectives only for the purpose of allowing for distinction between the nouns that they modify from one another, and not for the purpose of describing any particular relationship between those nouns.

Additional features, aspects and advantages of implementations of the present technology will become apparent from the following description, the accompanying drawings and the appended claims.

### BRIEF DESCRIPTION OF THE DRAWINGS

For a better understanding of the present technology, as well as other aspects and further features thereof, reference is made to the following description which is to be used in conjunction with the accompanying drawings, where:
FIG. 1 illustrates a high-level functional block diagram of a maintenance cleansing system for a liquid-cooled rack-mounted data processing assembly, in accordance with the nonlimiting embodiments of the present technology;
FIG. 2 illustrates a high-level block diagram for the operational configuration of fluid control structures, in accordance with the nonlimiting embodiments of the present technology;
FIG. 3 illustrates a high-level flow diagram for maintenance cleansing process of a liquid-cooled rack-mounted data processing assembly, in accordance with the nonlimiting embodiments of the present technology; and
FIG. 4 depicts a schematic block diagram of a control module, in accordance with the nonlimiting embodiments of the present technology.

It should be appreciated that, unless otherwise explicitly specified herein, the drawings are not to scale.

### DETAILED DESCRIPTION

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology without departing from the scope of the appended claims.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology. Further, where no examples of modifications have been set forth, it should not be interpreted that no modifications are possible and/or that what is described is the sole manner of implementing that element of the present technology.

It will be appreciated by those skilled in the art that any block diagrams herein represent conceptual views of illustrative circuitry embodying the principles of the present technology. Similarly, it will be appreciated that any flowcharts, flow diagrams, state transition diagrams, pseudo-code, and the like represent various processes that may be substantially represented in non-transitory computer-readable media and so executed by a computer or processor, whether or not such computer or processor is explicitly shown.

The functions of the various elements shown in the FIGs. including any functional block labeled as a "processor", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. In some embodiments of the present technology, the processor may be a general-purpose processor, such as a central processing unit (CPU) or a processor dedicated to a specific purpose, such as a digital signal processor (DSP). Moreover, explicit use of the term a "processor" should not be construed to refer exclusively to hardware capable of executing software, and may implicitly include, without limitation, application specific integrated circuit (ASIC), field programmable gate array (FPGA), read-only memory (ROM) for storing software, random access memory (RAM), and non-volatile storage. Other hardware, conventional and/or custom, may also be included.

Software modules, or simply modules which are implied to be software, may be represented herein as any combination of flowchart elements or other elements indicating performance of process steps and/or textual description. Such modules may be executed by hardware that is expressly or implicitly shown. Moreover, it should be understood that module may include for example, but without being limitative, computer program logic, computer program instructions, software, stack, firmware, hardware circuitry or a combination thereof which provides the required capabilities.

Given this fundamental understanding, the disclosed embodiments are directed to a cleansing system for liquid-cooled rack-mounted processing assemblies that is configured to eliminate the buildup of undesirable contaminants as well as reduce reoccurrences of the same in direct liquid cooling block implementations. The cleansing system is capable of executing cleaning cycles while processing assemblies are in operation with no downtime.

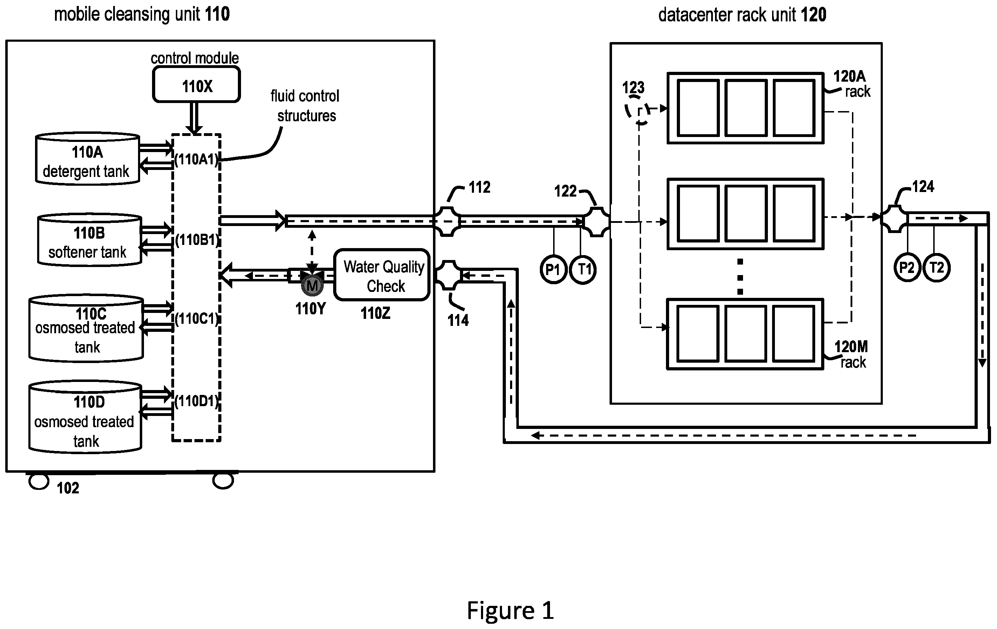

FIG. 1 illustrates a illustrates a high-level functional block diagram of a maintenance cleansing system 100 for a liquid-cooled rack-mounted data processing assembly, in accordance with the nonlimiting embodiments of the present technology. As depicted, maintenance cleansing system **100** generally comprises a cleansing unit **110** that is in fluid communication and contact with a datacenter rack unit **120.**

Starting with the datacenter rack unit **120,** the rack unit **120** may house a rack or a plurality of racks **120A-120M,** in which each rack comprises one or more rack-mounted data processing assemblies. Each of the rack-mounted data processing assemblies contains heat-generating processing components (*not shown*) such as servers which are cooled by liquid cooling blocks (*not shown*), also called "water blocks", that are arranged to be in direct thermal contact with the heat-generating components.

In turn, each of the liquid cooling blocks employs internal channels that are fluidly-coupled to a rack liquid cooling loop **123** which conveys cooling liquid (e.g. water) and circulates the channelized cool cooling liquid internally throughout the liquid cooling blocks as well as conveys the warm cooling liquid heated by the heat-generating components for further cooling processing. The server rack liquid cooling loop **123** may be constructed from flexible materials (*e.g.,* rubber, plastic, *etc.*)*,* rigid materials (*e.g.,* metal, PVC piping, *etc.*)*,* or any combination of thereof capable of securely conveying and circulating cool cooling liquid.

The datacenter rack unit **120** also implements a rack unit liquid inlet **122** and a rack unit liquid outlet **124.** The liquid inlet **122** is fluidly coupled to an input side of the server rack liquid cooling loop **123** to supply cool cooling liquid to the liquid cooling blocks and incorporates a pressure sensor P1 and a temperature sensor T1 to monitor the pressure and temperature values of the liquid ingressing into the rack unit **120** via the rack liquid cooling loop **123.** The pressure sensor P1 and a temperature sensor T1 respectively provide pressure and temperature values to determine whether that the proper liquid flow pressure and temperature entering the rack unit **120** are capable of maintaining the continued operations of the data processing assemblies in the racks **120A-120M.**

The rack unit liquid outlet **124** is fluidly-coupled to an output side of the liquid cooling loop **123** to receive warm cooling liquid from the liquid cooling blocks that are heated due to the heat-generating components and incorporates a pressure sensor P2 and a temperature sensor T2 to monitor the pressure and temperature values of the liquid egressing from the rack unit **120** via the rack liquid cooling loop **123.** The pressure sensor P2 and a temperature sensor T2 respectively provide pressure and temperature values to determine whether that the proper liquid flow pressure and temperature exiting the rack unit **120** are maintaining the continued operations of the data processing assemblies of the racks **120A-120M.**

For cleansing purposes, the present technology exploits the infrastructure provided by the liquid inlet **122,** liquid cooling loop **123,** and liquid outlet **124** to distribute various cleansing liquids, in accordance with specified cleansing cycles, from the cleansing unit **110** throughout the liquid cooling loop **123** and the return of the cleansing liquids containing contaminant residues (*i.e.,* "dirty liquids") back to cleansing unit **110.**

Turning to the cleansing unit **110** of FIG. 1, the cleansing unit **110** comprises a plurality of liquid tanks **110A-110D,** a controller, or "control module" **110X,** a fluid control structure **110A1-110D1**corresponding to each of the liquid tanks, a forward fluid coupling section **112,** a return fluid coupling section **114,** a water quality check (WQC) bench **110Z,** and a motorized three-way valve **110Y.**

Each of the plurality of liquid tanks **110A-110D** contains a volume of a liquid having specific cleansing/treatment properties. In certain embodiments, a first tank **110A** contains a first volume of liquid including a detergent having an acidic ph level. The detergent contains citric-based additive agents for the effective and environmentally-friendly removal of a variety of mineral deposits and contaminants. A second tank **110B** contains a second volume of liquid comprising water softening additive agents or pure water to ionically remove mineral deposits. A third tank **110C** contains a third volume of liquid comprising osmosed water with corrosion inhibitors having a basic ph level to provide a cooling fluid substantially free of contaminants.

In certain implementations, the mobile cleansing unit **110** may include a fourth tank **110D** that contains a fourth volume of liquid also including osmosed water with corrosion inhibitors having a basic ph level to provide a cooling fluid free of contaminants.

As noted above, the mobile cleansing unit **110** further comprises a forward fluid coupling section **112,** a return fluid coupling section **114,** a water quality check (WQC) bench **110Z,** and a motorized three-way valve **110Y.** The forward fluid coupling section **112** operates to fluidly convey the liquid from a selected tank **110A-110D** to the rack unit **120** and the return fluid coupling section **114** operates to return the fluid distributed throughout the rack unit **120** back to the mobile cleansing unit **110.**

The WQC bench **110Z** is connected to the return fluid coupling section **114** comprising a pump (*not shown*) and water quality sensors (*not shown*) to measure certain liquid quality levels, such as, for example, pH level, electrical conductivity, aluminum, copper, and zinc content, aerobic microorganism content, *etc.* of the existing liquid circulating within the rack unit **120.** In certain implementations satisfactory liquid quality levels may encompass a pH balance of approximately between 8 and 10, an electrical conductivity of approximately less than 170 (µS/cm), an aluminum, copper, and zinc content of approximately less than 0.6 ppm and an aerobic microorganism content of approximately less than 1000 cfu/ml.

With this WQC **110Z** configuration, when liquid from the rack unit **120** is connected to the mobile cleansing unit **110** via return fluid coupling section **114,** WQC **110Z** may perform a pretest to determine if the returned liquid needs cleaning based on the quality levels measured by the sensors. If so, WQC **110Z** directs the motorized three-way valve **110Y** to open the fluid control structure **110A1-110D1** (*discussed below*) of a respective liquid tank **110A-110D.** Moreover, at the end of a predetermined cleansing cycle duration time ***t***, the returned liquid is tested again by WQC **110Z** to determine whether the quality levels are satisfactory or whether cleansing cycles should be repeated for one or more stages.

As shown in FIG. 1, each of the liquid tanks **110A-110D** is operably connected to a respective fluid control structure **110A1-110D1.** As will be described in greater detail below, the fluid control structures **110A1-110D1** function to actuate and control the circulation of the liquids based on a corresponding cleansing operational cycle and duration time while still maintaining the data processing assemblies **120A-120M** operational throughout the cleansing process.

The control module **110X** is configured to establish a corresponding cleansing operational cycle and cycle duration time for each of the liquids based on the cleansing/purifying properties of the individual liquids. The control module **110X** is further configured to be communicatively-coupled to each of the fluid control structures **110A1-110D1** to provide instructions regarding the actuation and control of the circulation of liquids during respective operational cleansing cycles and duration times.

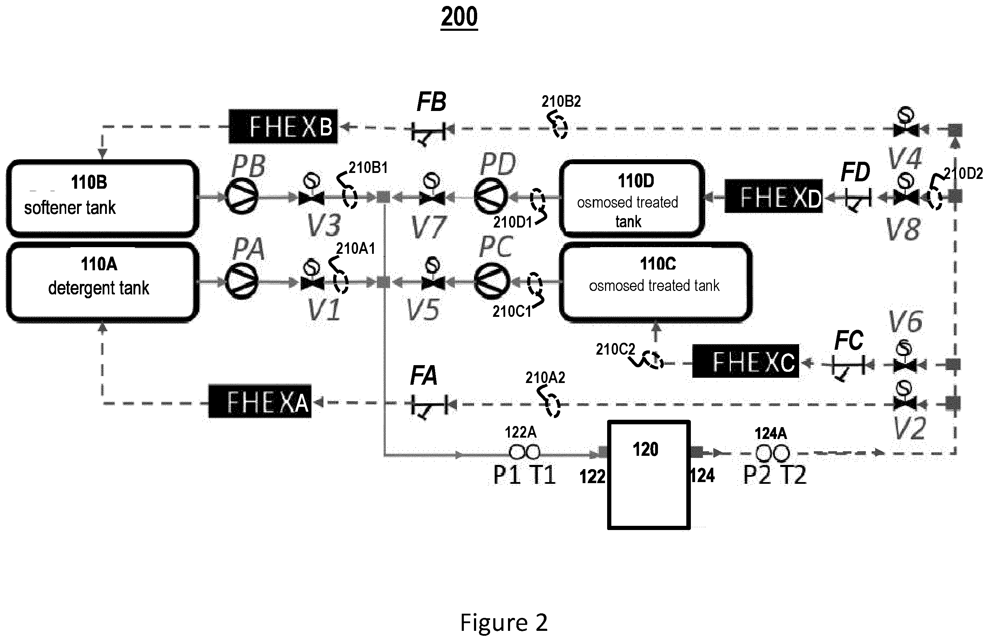

FIG. 2 depicts a high-level block diagram for an operational configuration **200** of fluid control structures **110A1-110D1,** in accordance with the nonlimiting embodiments of the present technology. As shown, configuration **200** depicts the fluid interconnection between each of the liquid tanks **110A-110D,** and the corresponding structural control/monitoring components, and the liquid circulation channels servicing the supply of liquids from the liquid tanks **110A-110D** to the data processing assemblies **120A-120M** of datacenter rack unit **120** and the return of the contaminated liquids, *i.e.,* "dirty liquids," from the rack unit **120** back to the respective tanks **110A-110D.**

Specifically, the fluid control structure **110A1** corresponding to the first liquid tank **110A** includes a first supply liquid channel **210A1** for forwarding the first liquid containing acidic detergent to the datacenter rack unit **120** and a first return liquid channel **210A2** for receiving the "dirty" detergent liquid from the datacenter rack unit **120.** As shown, the first supply liquid channel **210A1** comprises pump PA to provide a proper pressure for the first liquid flow into the datacenter rack unit **120** and a solenoid valve V1 that operates to enable the forward injection flow of the first liquid. The actuation, control, and duration time of pump PA and valve V1 for forwarding the injection flow of the first liquid are mandated by the first liquid cleansing operational cycle and duration time established by the control module **110X.**

The first return liquid channel **210A2** includes a solenoid valve V2, a filter FA, and an air-to-liquid heat exchanger FHEXA. The valve V2 enables the return flow of the first "dirty" detergent liquid from the datacenter rack unit **120,** the filter FA functions to re-cleanse the "dirty" detergent liquid by substantially removing the contaminants therein, and the air-to-liquid heat exchanger FHEXA functions to re-cool the re-cleansed detergent liquid and return back to first liquid detergent tank **110A** for recirculation until the corresponding cleansing cycle duration time has lapsed.

The remaining fluid control structures **110B1-110D1** of the corresponding the liquid tanks **110A-110D** are similarly structured. That is, the fluid control structure **110B1** corresponding to the second liquid tank **110B** includes a second supply liquid channel **210B1** for forwardly injecting the flow of the second liquid containing water softener agents to the datacenter rack unit **120** and a second return liquid channel **210B2** for receiving the second "dirty liquid" from the datacenter rack unit **120.**

The second supply liquid channel **210B1** includes a pump PB to provide a proper pressure for the second liquid flow into the datacenter rack unit **120** and a solenoid valve V3 to enable the forward injection flow of the second water softening liquid. The second return liquid channel **210B2** comprises a solenoid valve V4, a filter FB, and an air-to-liquid heat exchanger FHEXB. The valve V4 enables the return flow of the second "dirty" water softening liquid from the datacenter rack unit **120,** filter FB functions to re-cleanse the "dirty" water softening liquid by substantially removing the contaminants therein, and the air-to-liquid heat exchanger FHEXB functions to re-cool the re-cleansed water softening liquid and return back to second liquid detergent tank **110B** for recirculation until the corresponding cleansing cycle duration time has lapsed. The actuation, control, and duration time of pump PB, valves V3, V4, and the air-to-liquid heat exchanger FHEXB is mandated by the second liquid cleansing operational cycle and duration time established by the control module **110X.**

The fluid control structure **110C1** corresponding to the third liquid tank **110C** comprises a third supply liquid channel **210C1** for forwardly injecting the third liquid containing osmosed water treated with additives to the datacenter rack unit **120** and a third return liquid channel **210C2** for receiving the third "dirty" osmosed treated water from the datacenter rack unit **120.**

The third supply liquid channel **210C1** includes pump PC to provide a proper pressure for the third liquid flow into the datacenter rack unit **120** and a solenoid valve V5 to enable the forward injection flow of the third liquid into the datacenter rack unit **120.** The third return liquid channel **210C2** includes a solenoid valve V6, a filter FC, and an air-to-liquid heat exchanger FHEXC. The filter FC functions to re-cleanse the "dirty" osmosed treated water by substantially removing the contaminants therein, and the air-to-liquid heat exchanger FHEXC functions to re-cool the re-cleansed treated water and return back to third liquid detergent tank **110B** for recirculation until the corresponding cleansing cycle duration time has lapsed.

The actuation, control, and duration time of pump PC, valves V5, V6, and the air-to-liquid heat exchanger FHEXC is mandated by the third liquid cleansing operational cycle and duration time established by the control module **110X.**

In like fashion, the fluid control structure **110D1** corresponding to the fourth liquid tank **110D** comprises a fourth supply liquid channel **210D1** for forwardly injecting the fourth liquid containing osmosed water treated with additives to the datacenter rack unit **120** and a fourth return liquid channel **210D2** for receiving the fourth "dirty" osmosed treated water from the datacenter rack unit **120.**

The fourth supply liquid channel **210D1** comprises pump PD to provide a proper pressure for the third liquid flow into the datacenter rack unit **120** and a solenoid valve V7 to enable the forward injection flow of the fourth liquid into the datacenter rack unit **120.** The fourth return liquid channel **210D2** comprises a solenoid valve V8, a filter FD, and an air-to-liquid heat exchanger FHEXD. The filter FD functions to re-cleanse the "dirty" osmosed treated water by substantially removing the contaminants therein, and the air-to-liquid heat exchanger FHEXD functions to re-cool the re-cleansed treated water and return back to fourth liquid detergent tank **110B** for recirculation until the corresponding cleansing cycle duration time has lapsed.

The actuation, control, and duration time of the actuation of the pump PD, the valves V7, V8, and the air-to-liquid heat exchanger FHEXD are mandated by the fourth liquid cleansing operational cycle and duration time established by the control module **110X.**

Given the disclosed configuration, each of the fluid control structures **110A1-110D1** respectively connected to the liquid tanks **110A-110D** are designed to inject the appropriate cleansing liquids to the data processing assemblies **120A-120M** of datacenter rack unit **120** and return the "dirty" liquids back to the respective liquid tanks **110A-110D,** in accordance with the specific operational cleansing cycles and cycle duration times established by control module **110X.** As such, the cleansing cycles are capable of being executed while maintaining the data processing assemblies **120A-120M** operational throughout the cleansing process.

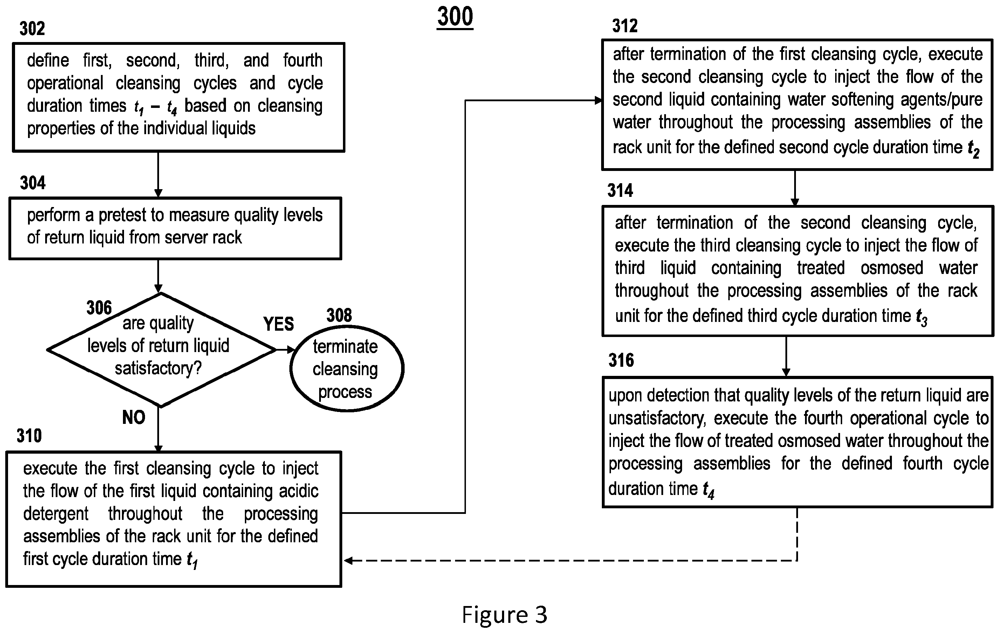

FIG. 3 illustrates a high-level flow diagram for a maintenance cleansing process **300,** in accordance with the nonlimiting implementations of the present technology. In the disclosed implementation, maintenance cleansing process **300** or portions thereof are referenced as being executed by control module **110X** for tractability purposes. However, the exact entity or entities executing maintenance cleansing process **300** should not be interpreted as being limiting with regard to the concepts provided by the instant disclosure.

With this said, maintenance cleansing process **300** commences at task block **302,** in which a first, second, third, and fourth operational cleansing cycle and corresponding cycle duration times ***t₁-t₄*** are defined based on the cleansing properties of the corresponding first, second, and third/fourth liquids. As noted above, the first liquid comprises a detergent having an acidic ph level, the second liquid comprises a water softening additive agent, and the third and fourth liquids comprise osmosed water with anti-corrosion additive agents having basic ph levels.

At task block **304,** cleansing process **300** performs a pretest to measure liquid quality levels of the liquid returned from the server rack, as detected by the sensors of WQC **110Z.** At decision block **306,** process **300** determines whether the quality levels of the return liquid are satisfactory and if so, process **300** terminates at block **308.** If not, process **300** moves to task block **310,** in which the first cleansing cycle is executed to inject the flow of the first liquid containing acidic detergent from the first tank **110A** throughout the data processing assemblies **120A-120M** of the datacenter rack unit **120,** via the liquid cooling loop **123,** and return the "dirty" first liquid back to the first tank **110A** for the defined first cycle duration time ***t₁.*** As noted above, task block **310** entails the timely actuation and control of pump PA, valves V1, V2, and heat exchanger FHEXA throughout duration of the first cycle.

Upon termination of the first cycle, process **300** executes the second cleansing cycle, at task block **312,** to inject the flow of the second liquid containing water softening agents throughout the data processing assemblies **120A-120M** of the datacenter rack unit **120,** via the liquid cooling loop **123,** and return the "dirty" second liquid back to the second tank **110B** for the defined second cycle duration time. As noted above, task block **312** entails the timely actuation and control of pump PB, valves V3, V4, and heat exchanger FHEXB throughout duration of the second cycle.

At task block **314,** after termination of the second cleansing cycle, process **300** executes the third cleansing cycle to inject the flow of third liquid containing treated osmosed water throughout the data processing assemblies **120A-120M** of the datacenter rack unit **120,** via the liquid cooling loop **123,** and return the "dirty" third liquid back to the second tank **110A,** for the defined third cycle duration time. As noted above, task block **314** entails the timely actuation and control of pump PC, valves V5, V6, and heat exchanger FHEXC throughout duration of the third cycle.

At task block **316,** upon detection that the quality levels of the return liquid, as measured by the sensors of WQC **110Z** are not satisfactory, at task block **316,** process **300** executes the fourth operational cycle to again inject the flow of treated osmosed water throughout the processing assemblies for the defined fourth cycle duration time to address any such issues.

Moreover, in the event that the quality levels of the return liquid still remain unsatisfactory, in certain implementations, process **300** may return back to task blocks **310** to **316** to repeat the execution of the first to fourth cleansing cycles.

In this manner, maintenance cleansing system **100** and maintenance cleansing process **300** effectively eliminate the buildup of undesirable contaminants as well as reduce reoccurrences of the same throughout liquid cooling configurations of rack-mounted data processing assemblies. Moreover, the cleansing system and process are capable of performing the cleaning cycles while the data processing assemblies are still in operation with no downtime.

While the above-described implementations regarding the cleansing process have been described and shown with reference to particular steps performed in a particular order, it will be understood that these steps may be combined, sub-divided, or re-ordered without departing from the teachings of the present technology. At least some of the steps may be executed in parallel or in series. Accordingly, the order and grouping of the steps is not a limitation of the present technology.

It will be appreciated that at least some of the operations of the process **300** may also be performed by computer programs, which may exist in a variety of forms, both active and inactive. Such as, the computer programs may exist as software program(s) comprised of program instructions in source code, object code, executable code or other formats. Any of the above may be embodied on a computer readable medium, which include storage devices and signals, in compressed or uncompressed form. Representative computer readable storage devices include conventional computer system RAM (random access memory), ROM (read only memory), EPROM (erasable, programmable ROM), EEPROM (electrically erasable, programmable ROM), and magnetic or optical disks or tapes. Representative computer readable signals, whether modulated using a carrier or not, are signals that a computer system hosting or running the computer program may be configured to access, including signals downloaded through the Internet or other networks. Concrete examples of the foregoing include distribution of the programs on a CD ROM or via Internet download. In a sense, the Internet itself, as an abstract entity, is a computer readable medium. The same is true of computer networks in general.

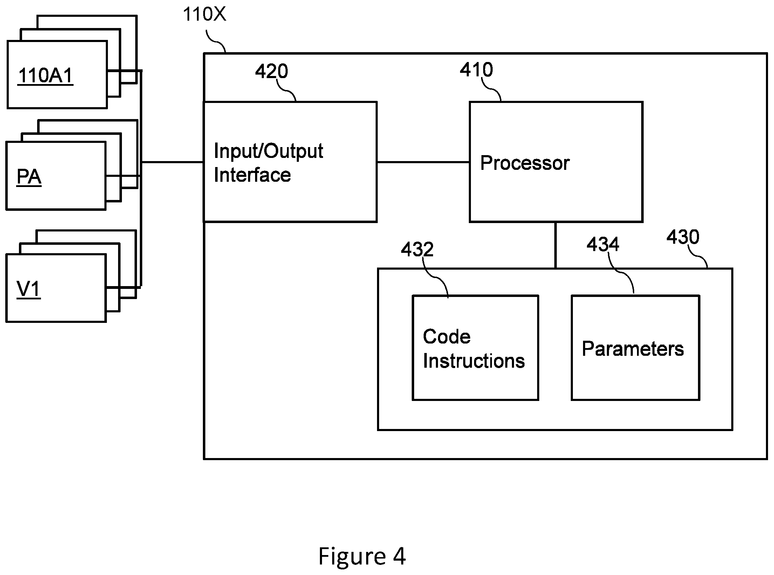

As an example, FIG. 4 is a schematic block diagram of the control module **110X** according to an embodiment of the present technology. The control module **110X** comprises a processor or a plurality of cooperating processors (represented as a processor **410** for simplicity), a memory device or a plurality of memory devices (represented as a memory device **430** for simplicity), and an input/output interface **420** allowing the control module **110X** to communicate with other components of the mobile cleansing unit **110** and/or other components in remote communication with the mobile cleansing unit **110.** The processor **410** is operatively connected to the memory device **430** and to the input/output interface **420.** The memory device 430 includes a storage for storing parameters **434.** The memory device **430** may comprise a non-transitory computer-readable medium for storing code instructions **432** that are executable by the processor **410** to allow the control module **110X** to perform the various tasks allocated to the control module **110X** in the process **300.**

The control module **110X** is operatively connected, via the input/output interface **420,** to the fluid control structures **110A1, 110B1, 110C1** and **110D1,** the pumps **PA, PB, PC,** and **PD,** the valves **V1** to **V8** and other components of the mobile cleansing unit **110.** The control module **110X** executes the code instructions **432** stored in the memory device **430** to implement the various above-described functions that may be present in a particular embodiment. FIG. 4 as illustrated represents a non-limiting embodiment in which the control module **110X** orchestrates operations of the mobile cleansing unit **110.** This particular embodiment is not meant to limit the present disclosure and is provided for illustration purposes.

Modifications and improvements to the above-described implementations of the present technology may become apparent to those skilled in the art. The foregoing description is intended to be exemplary rather than limiting. The scope of the present technology is therefore intended to be limited solely by the scope of the appended claims.

## Claims

1. A maintenance cleansing system (100) for a server rack (120) incorporating liquid-cooled rack-mounted data processing assemblies (120A-120M), comprising:
a cleansing unit (110) comprising:
a first tank (110A) containing a volume of a first liquid comprising a detergent having an acidic ph level and fluidly-coupled a first fluid control structure (110A1),
a second tank (110B) containing a volume of a second liquid comprising softened water or pure water and fluidly-coupled a second fluid control structure (110B1), and
a third tank (110C) containing a volume of a third liquid comprising treated osmosed water with corrosion inhibitors having a basic ph level and fluidly-coupled a third fluid control structure (110C1);
a control module (110X) operably-coupled to the first, second, and third fluid control structures (110A1-110C1) and configured to select one of the first, second, or third liquids and define a corresponding first, second, and third operational cleansing cycle and cycle duration time,
a forward fluid coupling section (112) configured to supply the selected liquid to the rack-mounted processing assemblies (120A-120M), and
a return fluid coupling section (114) configured to receive the selected liquid from the rack-mounted processing assemblies (120A-120M);
a rack unit (120) fluid inlet (122) configured to receive the selected fluid from the forward fluid coupling section (112) and distribute the selected liquid throughout each of the rack-mounted processing assemblies (120A-120M) for a corresponding cleansing cycle; and
a rack unit (120) fluid outlet (124) configured to receive the distributed selected liquid from each of the rack-mounted processing assemblies (120A-120M), during the corresponding cleansing cycle, and return the distributed selected liquid back to the respective tank.

2. The maintenance cleansing system (100) of claim 1, further comprising a fourth tank (110D) containing a volume of a fourth liquid comprising a volume of treated osmosed water with corrosion inhibitors having a basic ph level and fluidly-coupled to a fourth fluid control structure (110D1) for selection by the control module to establish a corresponding fourth cleansing cycle and cycle duration time.

3. The maintenance cleansing system (100) of claim 1 or 2, wherein the cleansing unit 110 further comprises a pump and water quality check (WQS) bench 110Z incorporating water quality sensors to measure liquid quality levels.

4. The maintenance cleansing system (100) of any one of claims 1 to 3, wherein each of the first, second, third, and fourth fluid control structures (110A1-110D1) comprises a respective supply liquid channel (210A1-201D1) incorporating at least one pump (PA-PD) and at least one solenoid valve (V1, V3, V5, V7) for providing proper pressure and flow of the selected liquid into the datacenter rack unit (120).

5. The maintenance cleansing system (100) of any one of claims 1 to 4, wherein each of the first, second, third, and fourth fluid control structures (110A1-110D1) comprises a respective return liquid channel (210A2-201D2) incorporating at least one filter (FA-FD) and at least one heat exchanger (FHEXA-FHEXD) for recleaning and recooling the returned selected liquid.

6. The maintenance cleansing system (100) of any one of claims 1 to 5, wherein the cleansing unit (110) is configured to perform the first, second, third, and fourth cleansing cycles while the data processing assemblies (120A-120M) remain in operation.

7. The maintenance cleansing system (100) of any one of claims 1 to 6, wherein the cleansing unit (110) further comprises a wheel assembly (102) for transportability throughout a datacenter.

8. The maintenance cleansing system (100) of claim 4, wherein the control module (110X) defines a first operational cycle configured to:
select the detergent from the first tank (110A);
activate the pump (PA) of the first control structure (110A1);
open the solenoid flow valve (V1) of the first control structure (110A1) to commence flow of the detergent to be distributed throughout the rack-mounted processing assemblies (120A-120M);
allow the distributional flow of the acidic detergent to continue for a first cycle duration time t₁; and
upon lapsing of the first cycle duration time t₁ and/or upon the WQS 110Z determining that the returning liquid from the processing assemblies (120A-120M) satisfies liquid quality levels, shut the solenoid valve (V1) and deactivate the pump (PA) of the first control structure (110A1) to terminate the distributional flow of the acidic detergent.

9. The maintenance cleansing system (100) of claim 4, wherein the control module (110X) defines a second operational cycle configured to:
select the softened water from the second tank (110B);
activate the pump (PB) of the second control structure (110B1);
open the solenoid flow valve (V3) of the second control structure (110B1) to commence flow of the softened water to be distributed throughout the rack-mounted processing assemblies (120A-120M);
allow the distributional flow of the softened water to continue for a second cycle duration time *t*₂; and
upon lapsing of the second cycle duration time *t*₂ and/or upon the WQS 110Z determining that the returning liquid from the processing assemblies (120A-120M) satisfies liquid quality levels, shut the solenoid valve (V3) and deactivate the pump (PB) of the second control structure (110B1) to terminate the distributional flow of the softened water.

10. The maintenance cleansing system (100) of claim 4, wherein the control module (110X) defines a third operational cycle configured to:
select the treated osmosed water from the third tank (110C);
activate the pump (PC) of the third control structure (110C1);
open the solenoid flow valve (V5) of the third control structure (110C1) to commence flow of the treated osmosed water to be distributed throughout the rack-mounted processing assemblies (120A-120M);
allow the distributional flow of treated osmosed water to continue for a third cycle duration time *t₃;* and
upon lapsing of the third cycle duration time *t₃* and/or upon the WQS 110Z determining that the returning liquid from the processing assemblies (120A-120M) satisfies liquid quality levels, shut the solenoid valve (V5) and deactivate the pump (PC) of the third control structure (110C1) to terminate the distributional flow of the treated osmosed water.

11. The maintenance cleansing system (100) claim 4, wherein the control module (110X) defines a fourth operational cycle configured to:
select the treated osmosed water from the fourth tank (110D);
activate the pump (PD) of the fourth control structure (110D1);
open the solenoid flow valve (V7) of the fourth control structure (110D1) to commence flow of the treated osmosed water to be distributed throughout the rack-mounted processing assemblies (120A-120M);
allow the distributional flow of treated osmosed water to continue for a fourth cycle duration time *t₄*; and
upon lapsing of the fourth cycle duration time *t₄* and/or upon the WQS 110Z determining that the returning liquid from the processing assemblies (120A-120M) satisfies liquid quality levels, shut the solenoid valve (V7) and deactivate the pump (PD) of the fourth control structure (110C1) to terminate the distributional flow of the treated osmosed water.

12. A maintenance process (300) for cleansing a server rack (120) incorporating liquid-cooled rack-mounted data processing assemblies (120A-120M), comprising:
defining an operational cleansing cycle and duration time, respectively, for a first liquid comprising a detergent having an acidic ph level, a second liquid comprising water softening agents, and a third cleansing liquid comprising treated osmosed water having a basic ph level;
performing a pretest to measure quality levels of liquid returned from the server rack, as detected by water quality sensors;
upon determining that the quality levels of the return liquid are unsatisfactory, executing:
selecting the first liquid and executing the first operational cleansing cycle for the first duration time *t₁* to inject and circulate the flow of the first liquid throughout the processing assemblies;
upon termination of the first operational cleansing cycle, selecting the second liquid and executing the second operational cleansing cycle for the second duration time *t*₂ to inject and circulate the flow of the second liquid throughout the processing assemblies; and
upon termination of the second operational cleansing cycle, selecting the third liquid and executing the third operational cleansing cycle for the third duration time *t₃* to inject and circulate the flow of the third liquid throughout the processing assemblies.

13. The maintenance process (300) of claim 12, further comprising defining an operational cleansing cycle and duration time *t₄* for a fourth liquid comprising treated osmosed water having a basic ph level and executing the fourth cleansing cycle upon determining that the return liquid from the server rack exhibits unsatisfactory quality levels, as detected by the water quality sensors.

14. The maintenance process (300) of claim 13, wherein, upon determining that, after the fourth cleansing cycle, the return liquid from the server rack continues to exhibit unsatisfactory quality levels, as detected by the water quality sensors, revert back to executing the first to fourth operational cleansing cycles.

15. The maintenance process (300) of any one of claims 12 to 14, wherein the liquid quality levels comprise pH level, electrical conductivity, aluminum, copper, and zinc content, and/or aerobic microorganism content.

## Patentansprüche

1. Wartungsreinigungssystem (100) für ein Servergestell (120), das flüssigkeitsgekühlte gestellmontierte Datenverarbeitungsanordnungen (120A-120M) integriert, umfassend:
eine Reinigungseinheit (110), umfassend:
einen ersten Tank (110A), der ein Volumen einer ersten Flüssigkeit enthält, die ein Reinigungsmittel mit einem sauren pH-Wert umfasst, und der mit einer ersten Fluid-Steuerkonstruktion (110A1) fluidgekoppelt ist,
einen zweiten Tank (110B), der ein Volumen einer zweiten Flüssigkeit enthält, die enthärtetes Wasser oder reines Wasser umfasst, und der mit einer zweiten Fluid-Steuerkonstruktion (110B1) fluidgekoppelt ist, und
einen dritten Tank (110C), der ein Volumen einer dritten Flüssigkeit enthält, die behandeltes osmosiertes Wasser mit Korrosionshemmern mit einem basischen pH-Wert umfasst, und der mit einer dritten Fluid-Steuerkonstruktion (110C1) fluidgekoppelt ist;
ein Steuermodul (110X), das an die erste, zweite und dritte Fluid-Steuerkonstruktion (110A1-110C1) wirkgekoppelt und dazu konfiguriert ist, eine von der ersten, zweiten oder dritten Flüssigkeit auszuwählen und einen entsprechenden ersten, zweiten und dritten Betriebsreinigungszyklus und eine entsprechende erste, zweite und dritte Zyklusdauer zu definieren,
einen Vorwärts-Fluid-Kopplungsabschnitt (112), der dazu konfiguriert ist, die ausgewählte Flüssigkeit den gestellmontierten Verarbeitungsanordnungen (120A-120M) zuzuführen, und
einen Rücklauf-Fluid-Kopplungsabschnitt (114), der dazu konfiguriert ist, die ausgewählte Flüssigkeit von den gestellmontierten Verarbeitungsanordnungen (120A-120M) aufzunehmen;
einen Fluideinlass (122) der Gestelleinheit (120), der dazu konfiguriert ist, das ausgewählte Fluid von dem Vorwärts-Fluid-Kopplungsabschnitt (112) aufzunehmen und die ausgewählte Flüssigkeit durch jede der gestellmontierten Verarbeitungsanordnungen (120A-120M) für einen entsprechenden Reinigungszyklus zu verteilen; und
einen Fluidauslass (124) der Gestelleinheit (120), der dazu konfiguriert ist, das verteilte ausgewählte Fluid von jeder der gestellmontierten Verarbeitungsanordnungen (120A-120M) während des entsprechenden Reinigungszyklus aufzunehmen und die verteilte ausgewählte Flüssigkeit zu dem jeweiligen Tank zurückzuführen.

2. Wartungsreinigungssystem (100) nach Anspruch 1, ferner umfassend einen vierten Tank (110D), der ein Volumen einer vierten Flüssigkeit enthält, die ein Volumen von behandeltem osmosiertem Wasser mit Korrosionshemmern mit einem basischen pH-Wert umfasst, und der an eine vierte Fluid-Steuerkonstruktion (110D1) zur Auswahl durch das Steuermodul fluidgekoppelt ist, um einen entsprechenden vierten Reinigungszyklus und eine vierte Zyklusdauer festzulegen.

3. Wartungsreinigungssystem (100) nach Anspruch 1 oder 2, wobei die Reinigungseinheit 110 ferner eine Pumpe und eine Bank 110Z zur Wasserqualitätsprüfung (water quality check - WQS) umfasst, die Wasserqualitätssensoren integriert, um Flüssigkeitsqualitätsstufen zu messen.

4. Wartungsreinigungssystem (100) nach einem der Ansprüche 1 bis 3, wobei jede von der ersten, zweiten, dritten und vierten Fluid-Steuerkonstruktion (110A1-110D1) einen jeweiligen Versorgungsflüssigkeitskanal (210A1-201D1) umfasst, der mindestens eine Pumpe (PA-PD) und mindestens ein Magnetventil (V1, V3, V5, V7) integriert, um einen angemessenen Druck und Durchfluss der ausgewählten Flüssigkeit in die Gestelleinheit (120) eines Rechenzentrums bereitzustellen.

5. Wartungsreinigungssystem (100) nach einem der Ansprüche 1 bis 4, wobei jede von der ersten, zweiten, dritten und vierten Fluid-Steuerkonstruktion (110A1-110D1) einen jeweiligen Rücklaufflüssigkeitskanal (210A2-201D2) umfasst, der mindestens ein Filter (FA-FD) und mindestens einen Wärmetauscher (FHEXA-FHEXD) integriert, um die zurückgeführte ausgewählte Flüssigkeit erneut zu reinigen und erneut zu kühlen.

6. Wartungsreinigungssystem (100) nach einem der Ansprüche 1 bis 5, wobei die Reinigungseinheit (110) dazu konfiguriert ist, den ersten, zweiten, dritten und vierten Reinigungszyklus durchzuführen, während die Datenverarbeitungsanordnungen (120A-120M) in Betrieb bleiben.

7. Wartungsreinigungssystem (100) nach einem der Ansprüche 1 bis 6, wobei die Reinigungseinheit (110) ferner eine Radanordnung (102) für die Transportierbarkeit durch ein Rechenzentrum umfasst.

8. Wartungsreinigungssystem (100) nach Anspruch 4, wobei das Steuermodul (110X) einen ersten Betriebszyklus definiert, der zu Folgendem konfiguriert ist:
Auswählen des Reinigungsmittels aus dem ersten Tank (110A);
Anschalten der Pumpe (PA) der ersten Steuerkonstruktion (110A1);
Öffnen des Magnetdurchflussventils (V1) der ersten Steuerkonstruktion (110A1), um den Durchfluss des Reinigungsmittels zu starten, das durch die gestellmontierten Verarbeitungsanordnungen (120A-120M) zu verteilen ist;
Ermöglichen, dass der Verteilungsdurchfluss des sauren Reinigungsmittels für eine erste Zyklusdauer *t₁* fortgesetzt wird; und
nach Ablauf der ersten Zyklusdauer *t₁* und/oder wenn die WQS 110Z bestimmt, dass die rücklaufende Flüssigkeit aus den Verarbeitungsanordnungen (120A-120M) Flüssigkeitsqualitätsstufen erfüllt, Schließen des Magnetventils (V1) und Abschalten der Pumpe (PA) der ersten Steuerkonstruktion (110A1), um den Verteilungsdurchfluss des sauren Reinigungsmittels zu beenden.

9. Wartungsreinigungssystem (100) nach Anspruch 4, wobei das Steuermodul (110X) einen zweiten Betriebszyklus definiert, der zu Folgendem konfiguriert ist:
Auswählen des enthärteten Wassers aus dem zweiten Tank (110B);
Anschalten der Pumpe (PB) der zweiten Steuerkonstruktion (110B1);
Öffnen des Magnetdurchflussventils (V3) der zweiten Steuerkonstruktion (110B1), um den Durchfluss des enthärteten Wassers zu starten, das durch die gestellmontierten Verarbeitungsanordnungen (120A-120M) zu verteilen ist;
Ermöglichen, dass der Verteilungsdurchfluss des enthärteten Wassers für eine zweite Zyklusdauer *t*₂ fortgesetzt wird; und nach Ablauf der zweiten Zyklusdauer *t*₂ und/oder wenn die WQS 110Z bestimmt, dass die rücklaufende Flüssigkeit aus den Verarbeitungsanordnungen (120A-120M) Flüssigkeitsqualitätsstufen erfüllt, Schließen des Magnetventils (V3) und Abschalten der Pumpe (PB) der zweiten Steuerkonstruktion (110B1), um den Verteilungsdurchfluss des enthärteten Wassers zu beenden.

10. Wartungsreinigungssystem (100) nach Anspruch 4, wobei das Steuermodul (110X) einen dritten Betriebszyklus definiert, der zu Folgendem konfiguriert ist:
Auswählen des behandelten osmosierten Wassers aus dem dritten Tank (110C);
Anschalten der Pumpe (PC) der dritten Steuerkonstruktion (110C1);
Öffnen des Magnetdurchflussventils (V5) der dritten Steuerkonstruktion (110C1), um den Durchfluss des behandelten osmosierten Wassers zu starten, das durch die gestellmontierten Verarbeitungsanordnungen (120A-120M) zu verteilen ist;
Ermöglichen, dass der Verteilungsdurchfluss des behandelten osmosierten Wassers für eine dritte Zyklusdauer *t₃* fortgesetzt wird; und
nach Ablauf der dritten Zyklusdauer *t₃* und/oder wenn die WQS 110Z bestimmt, dass die rücklaufende Flüssigkeit aus den Verarbeitungsanordnungen (120A-120M) Flüssigkeitsqualitätsstufen erfüllt, Schließen des Magnetventils (V5) und Abschalten der Pumpe (PC) der dritten Steuerkonstruktion (110C1), um den Verteilungsdurchfluss des behandelten osmosierten Wassers zu beenden.

11. Wartungsreinigungssystem (100) nach Anspruch 4, wobei das Steuermodul (110X) einen vierten Betriebszyklus definiert, der zu Folgendem konfiguriert ist:
Auswählen des behandelten osmosierten Wassers aus dem vierten Tank (110D);
Anschalten der Pumpe (PD) der vierten Steuerkonstruktion (110D1);
Öffnen des Magnetdurchflussventils (V7) der vierten Steuerkonstruktion (110D1), um den Durchfluss des behandelten osmosierten Wassers zu starten, das durch die gestellmontierten Verarbeitungsanordnungen (120A-120M) zu verteilen ist;
Ermöglichen, dass der Verteilungsdurchfluss des behandelten osmosierten Wassers für eine vierte Zyklusdauer t₄ fortgesetzt wird; und
nach Ablauf der vierten Zyklusdauer t₄ und/oder wenn die WQS 110Z bestimmt, dass die rücklaufende Flüssigkeit aus den Verarbeitungsanordnungen (120A-120M) Flüssigkeitsqualitätsstufen erfüllt, Schließen des Magnetventils (V7) und Abschalten der Pumpe (PD) der vierten Steuerkonstruktion (110C1), um den Verteilungsdurchfluss des behandelten osmosierten Wassers zu beenden.

12. Wartungsprozess (300) zum Reinigen eines Servergestells (120), das flüssigkeitsgekühlte gestellmontierte Datenverarbeitungsanordnungen (120A-120M) integriert, umfassend:
Definieren eines Betriebsreinigungszyklus bzw. einer Betriebsdauer für eine erste Flüssigkeit, die ein Reinigungsmittel mit einem sauren pH-Wert umfasst, eine zweite Flüssigkeit, die Wasserenthärtungsmittel umfasst, und eine dritte Reinigungsflüssigkeit, die behandeltes osmosiertes Wasser mit einem basischen pH-Wert umfasst;
Durchführen eines Vortests, um die Qualitätsstufen der aus dem Servergestell zurückgeführten Flüssigkeit, wie durch die Wasserqualitätssensoren erfasst, zu messen;
wenn bestimmt wird, dass die Qualitätsstufen der Rücklaufflüssigkeit nicht zufriedenstellend sind, Ausführen von Folgendem:
Auswählen der ersten Flüssigkeit und Ausführen des ersten Betriebsreinigungszyklus für die erste Zeitdauer *t₁*, um den Durchfluss der ersten Flüssigkeit in die Verarbeitungsanordnungen einzuspritzen und durch diese zirkulieren zu lassen;
nach Beendigung des ersten Betriebsreinigungszyklus, Auswählen der zweiten Flüssigkeit und Ausführen des zweiten Betriebsreinigungszyklus für die zweite Zeitdauer t₂, um den Durchfluss der zweiten Flüssigkeit in die Verarbeitungsanordnungen einzuspritzen und durch diese zirkulieren zu lassen; und
nach Beendigung des zweiten Betriebsreinigungszyklus, Auswählen der dritten Flüssigkeit und Ausführen des dritten Betriebsreinigungszyklus für die dritte Zeitdauer *t₃*, um den Durchfluss der dritten Flüssigkeit in die Verarbeitungsanordnungen einzuspritzen und durch diese zirkulieren zu lassen.

13. Wartungsprozess (300) nach Anspruch 12, ferner umfassend Definieren eines Betriebsreinigungszyklus und einer Zeitdauer t₄ für eine vierte Flüssigkeit, die behandeltes osmosiertes Wasser mit einem basischen pH-Wert umfasst, und Ausführen des vierten Reinigungszyklus, wenn bestimmt wird, dass die Rücklaufflüssigkeit aus dem Servergestell nicht zufriedenstellende Qualitätsstufen zeigt, wie durch die Wasserqualitätssensoren erfasst.

14. Wartungsprozess (300) nach Anspruch 13, wobei, wenn bestimmt wird, dass die Rücklaufflüssigkeit aus dem Servergestell nach dem vierten Reinigungszyklus weiterhin nicht zufriedenstellende Qualitätsstufen zeigt, wie durch die Wasserqualitätssensoren erfasst, zum Ausführen des ersten bis vierten Betriebsreinigungszyklus zurückgekehrt wird.

15. Wartungsprozess (300) nach einem der Ansprüche 12 bis 14, wobei die Flüssigkeitsqualitätsstufen pH-Wert, elektrische Leitfähigkeit, Gehalt an Aluminium, Kupfer und Zink und/oder Gehalt an aeroben Mikroorganismen umfassen.

## Revendications

1. Système de nettoyage et de maintenance (100) pour un rack de serveur (120) intégrant des ensembles de traitement (120A-120M) de données montées en rack et refroidis par liquide, comprenant :
une unité de nettoyage (110) comprenant :
un premier réservoir (110A) contenant un volume d'un premier liquide comprenant un détergent présentant un niveau de pH acide et accouplé fluidiquement à une première structure de régulation (110A1) de fluide,
un deuxième réservoir (110B) contenant un volume d'un deuxième liquide comprenant de l'eau adoucie ou de l'eau pure et accouplé fluidiquement à une deuxième structure de régulation de fluide (110B1), et
un troisième réservoir (110C) contenant un volume d'un troisième liquide comprenant de l'eau osmosée traitée avec des inhibiteurs de corrosion présentant un niveau de pH basique et accouplé fluidiquement à une troisième structure de régulation de fluide (110C1) ;
un module de régulation (110X) accouplé de manière opérationnelle aux première, deuxième et troisième structures de régulation de fluide (110A1-110C1) et configuré pour sélectionner l'un parmi les premier, deuxième ou troisième liquides et pour définir des premier, deuxième et troisième cycles de nettoyage opérationnels correspondant et une durée de cycle,
une section d'accouplement de fluide avant (112) configurée pour fournir le liquide sélectionné aux ensembles de traitement (120A-120M) montés en rack, et
une section d'accouplement de fluide de retour (114) configurée pour recevoir le liquide sélectionné à partir des ensembles de traitement (120A-120M) montés sur rack ;
une entrée de fluide (122) d'unité de rack (120) configurée pour recevoir le fluide sélectionné à partir de la section d'accouplement de fluide avant (112) et pour distribuer le liquide sélectionné à travers chacun des ensembles de traitement (120A-120M) montés sur rack pour un cycle de nettoyage correspondant ; et
une sortie de fluide (124) de l'unité de rack (120) configurée pour recevoir le liquide sélectionné distribué à partir de chacun des ensembles de traitement (120A-120M) montés sur rack, pendant le cycle de nettoyage correspondant, et pour remettre le liquide sélectionné distribué vers le réservoir respectif.

2. Système de nettoyage de maintenance (100) selon la revendication 1, comprenant en outre un quatrième réservoir (110D) contenant un volume d'un quatrième liquide comprenant un volume d'eau osmosée traitée avec des inhibiteurs de corrosion présentant un niveau de pH basique et accouplé fluidiquement à une quatrième structure de régulation de fluide (110D1) pour la sélection par le module de régulation afin d'établir un quatrième cycle de nettoyage correspondant et une durée de cycle.

3. Système de nettoyage de maintenance (100) selon la revendication 1 ou 2, dans lequel l'unité de nettoyage 110 comprend en outre une pompe et un banc de vérification de qualité d'eau (WQS) 110Z intégrant des capteurs de qualité d'eau pour mesurer des niveaux de qualité de liquide.

4. Système de nettoyage de maintenance (100) selon l'une quelconque des revendications 1 à 3, dans lequel chacune des première, deuxième, troisième et quatrième structures de régulation de fluide (110A1-110D1) comprend un canal de liquide d'alimentation (210A1-201D1) respectif intégrant au moins une pompe (PA-PD) et au moins une vanne électromagnétique (V1, V3, V5, V7) destinées à fournir une pression et un écoulement appropriés du liquide sélectionné dans l'unité de rack (120) de centre de données.

5. Système de nettoyage de maintenance (100) selon l'une quelconque des revendications 1 à 4, dans lequel chacune des première, deuxième, troisième et quatrième structures de régulation de fluide (110A1-110D1) comprend un canal de liquide de retour (210A2-201D2) respectif intégrant au moins un filtre (FA-FD) et au moins un échangeur de chaleur (FHEXA-FHEXD) destinés à nettoyer et à refroidir à nouveau le liquide sélectionné remis.

6. Système de nettoyage de maintenance (100) selon l'une quelconque des revendications 1 à 5, dans lequel l'unité de nettoyage (110) est configurée pour effectuer les premier, deuxième, troisième et quatrième cycles de nettoyage pendant que les ensembles de traitement (120A-120M) de données restent en fonctionnement.

7. Système de nettoyage de maintenance (100) selon l'une quelconque des revendications 1 à 6, dans lequel l'unité de nettoyage (110) comprend en outre un ensemble roue (102) pour la transportabilité à travers un centre de données.

8. Système de nettoyage de maintenance (100) selon la revendication 4, dans lequel le module de régulation (110X) définit un premier cycle opérationnel configuré pour :
sélectionner le détergent à partir du premier réservoir (110A) ;
activer la pompe (PA) de la première structure de régulation (110A1) ;
ouvrir la vanne électromagnétique (V1) de réglage de la première structure de régulation (110A1) afin de commencer un écoulement du détergent à distribuer à travers les ensembles de traitement (120A-120M) montés en rack ;
permettre à un écoulement de distribution du détergent acide de se poursuivre pendant une première durée de cycle *t₁* ; et
à l'expiration de la première durée de cycle *t₁* et/ou lorsque le WQS 110Z détermine que le liquide de retour à partir des ensembles de traitement (120A-120M) satisfait aux niveaux de qualité de liquide, fermer la vanne électromagnétique (V1) et désactiver la pompe (PA) de la première structure de régulation (110A1) afin de terminer l'écoulement de distribution du détergent acide.

9. Système de nettoyage de maintenance (100) selon la revendication 4, dans lequel le module de régulation (110X) définit un deuxième cycle opérationnel configuré pour :
sélectionner l'eau adoucie à partir du deuxième réservoir (110B) ;
activer la pompe (PB) de la deuxième structure de régulation (110B1) ;
ouvrir la vanne électromagnétique (V3) de réglage de la deuxième structure de régulation (110B1) afin de commencer un écoulement de l'eau adoucie à distribuer à travers les ensembles de traitement (120A-120M) montés en rack ;
permettre à l'écoulement de distribution de l'eau adoucie de se poursuivre pendant une deuxième durée de cycle *t*₂ ; et
à l'expiration de la deuxième durée de cycle *t*₂ et/ou lorsque le WQS 110Z détermine que le liquide de retour à partir des ensembles de traitement (120A-120M) satisfait aux niveaux de qualité de liquide, fermer la vanne électromagnétique (V3) et désactiver la pompe (PB) de la deuxième structure de régulation (110B1) afin de terminer l'écoulement de distribution de l'eau adoucie.

10. Système de nettoyage de maintenance (100) selon la revendication 4, dans lequel le module de régulation (110X) définit un troisième cycle opérationnel configuré pour :
sélectionner l'eau osmosée traitée à partir du troisième réservoir (110C) ;
activer la pompe (PC) de la troisième structure de régulation (110C1) ;
ouvrir la vanne électromagnétique (V5) de réglage de la troisième structure de régulation (110C1) afin de commencer un écoulement de l'eau osmosée traitée à distribuer à travers les ensembles de traitement (120A-120M) montés en rack ;
permettre à l'écoulement de distribution de l'eau osmosée traitée de se poursuivre pendant une troisième durée de cycle *t₃* ; et
à l'expiration de la troisième durée de cycle *t₃* et/ou lorsque le WQS 110Z détermine que le liquide de retour à partir des ensembles de traitement (120A-120M) satisfait aux niveaux de qualité de liquide, fermer la vanne électromagnétique (V5) et désactiver la pompe (PC) de la troisième structure de régulation (110C1) afin de terminer l'écoulement de distribution de l'eau osmosée traitée.

11. Système de nettoyage de maintenance (100) selon la revendication 4, dans lequel le module de régulation (110X) définit un quatrième cycle opérationnel configuré pour :
sélectionner l'eau osmosée traitée à partir du quatrième réservoir (110D) ;
activer la pompe (PD) de la quatrième structure de régulation (110D1) ;
ouvrir la vanne électromagnétique (V7) de réglage de la quatrième structure de régulation (110D1) afin de commencer un écoulement de l'eau osmosée traitée à distribuer à travers les ensembles de traitement (120A-120M) montés en rack ;
permettre à l'écoulement de distribution de l'eau osmosée traitée de se poursuivre pendant une quatrième durée de cycle *t₄* ; et
à l'expiration de la quatrième durée de cycle *t₄* et/ou lorsque le WQS 110Z détermine que le liquide de retour à partir des ensembles de traitement (120A-120M) satisfait aux niveaux de qualité de liquide, fermer la vanne électromagnétique (V7) et désactiver la pompe (PD) de la quatrième structure de régulation (110C1) afin de terminer l'écoulement de distribution de l'eau osmosée traitée.

12. Procédé de maintenance (300) pour le nettoyage d'un rack de serveur (120) intégrant des ensembles de traitement (120A-120M) de données montés en rack et refroidis par liquide, comprenant :
la définition d'un cycle de nettoyage opérationnel et une durée, respectivement, pour un premier liquide comprenant un détergent présentant un niveau de pH acide, un deuxième liquide comprenant des adoucisseurs d'eau, et un troisième liquide de nettoyage comprenant de l'eau osmosée traitée présentant un niveau de pH basique ;
la réalisation d'un pré-test afin de mesurer des niveaux de qualité d'un liquide remis à partir du rack de serveur, tels que détectés par des capteurs de qualité d'eau ;
lors de la détermination du fait que les niveaux de qualité du liquide de retour ne sont pas satisfaisants, l'exécution de :
la sélection du premier liquide et l'exécution du premier cycle de nettoyage opérationnel pendant la première durée *t₁* afin d'injecter et de faire circuler l'écoulement du premier liquide à travers les ensembles de traitement ;
à la fin du premier cycle de nettoyage opérationnel, la sélection du deuxième liquide et l'exécution du deuxième cycle de nettoyage opérationnel pendant la deuxième durée *t*₂ afin d'injecter et de faire circuler l'écoulement du deuxième liquide à travers les ensembles de traitement ; et
à la fin du deuxième cycle de nettoyage opérationnel, la sélection du troisième liquide et l'exécution du troisième cycle de nettoyage opérationnel pendant la troisième durée *t₃* afin d'injecter et de faire circuler l'écoulement du troisième liquide à travers les ensembles de traitement.

13. Procédé de maintenance (300) selon la revendication 12, comprenant en outre la définition d'un cycle de nettoyage opérationnel et d'une durée *t₄* pour un quatrième liquide comprenant de l'eau osmosée traitée présentant un niveau de pH basique et l'exécution du quatrième cycle de nettoyage lors de la détermination du fait que le liquide de retour à partir du rack de serveur présente des niveaux de qualité insatisfaisants, tels que détectés par les capteurs de qualité d'eau.

14. Procédé de maintenance (300) selon la revendication 13, dans lequel, lors de la détermination du fait que, après le quatrième cycle de nettoyage, le liquide remis à partir du rack de serveur continue de présenter des niveaux de qualité insatisfaisants, tels que détectés par les capteurs de qualité d'eau, on revient à l'exécution des premier à quatrième cycles de nettoyage opérationnels.

15. Procédé de maintenance (300) selon l'une quelconque des revendications 12 à 14, dans lequel les niveaux de qualité de liquide comprennent un niveau de pH, une conductivité électrique, une teneur en aluminium, en cuivre et en zinc, et/ou une teneur en micro-organismes aérobies.
